# NEW EUROPEAN PATENT SPECIFICATION

(11) **EP 0 128 724 B2**
(45) Date of publication and mention of the opposition decision: **12.01.1994**
(45) Mention of the grant of the patent: 07.03.1990
(21) Application number: 84303761.5
(22) Date of filing: 05.06.1984
(51) Int. Cl.: H01L 21/324, H01L 21/318, H01L 31/10

(54) **Preparation of photodiodes**
Herstellung von Photodioden
Fabrication de photodiodes

(30) Priority: 13.06.1983 US 503795
(43) Date of publication of application: 19.12.1984
(73) Proprietor: AT&T Corp., New York, NY 10013-2412 (US)
(72) Inventor: Camlibel, Irfan, Stirling New Jersey 07982 (US); Singh, Shobha, Summit New Jersey 07901 (US); Van Uitert, LeGrand Gerard, Morristown New Jersey 07960 (US); Zuber, John Richard, Piscataway New Jersey 08854 (US); Zydzik, George John, Columbia New Jersey 07832 (US)
(74) Representative: Watts, Christopher Malcolm Kelway, Dr.

(56) References cited:
- NL-A- 8 001 232
- US-A- 4 226 667
- THIN solid films vol. 130, no. 1/2, May 1983, pages 17-26, Elsevier Sequoia, Lausanne, CH; J.D. OBERSTAR et al.: "Thin film encapsulants for annealing GaAs and inP"
- THIN SOLID FILMS, vol. 85, no. 1, October 1981, pages 61-69, Elsevier Sequioa, Lausanne, CH; J. WOODWARD: "The deposition of insulators onto inP using plasma enhanced chemical vapour deposition"
- PATENT ABSTRACTS OF JAPAN, vol. 7, no. 99 (E-72)[1244], 27th April 1983 & JP-A-58-21 822
- Japanese Journal of Applied Physics 19 (1980), p L675-678, N. Susa et al.: "Plasma enhanced CVD Si3N4 Film Applied to InP Avlanche Photodiodes"

## Description

The invention relates to procedures for making photodetectors using compound semiconductors formed on substrates containing phosphorus, for example photodetectors formed in InGaAs or InGaAsP films grown on substrates containing InP.

The development of optical communication systems has led to considerable activity in the optical device field. Various devices are of importance in optical communication systems, including sources (light-emitting diodes, lasers), transmission media (optical fibres) and detectors. The quality and characteristics of these devices (as well as other devices in the system) contribute significantly to the quality and efficiency of the optical communication system.

A particularly important part of the optical communication system is the photodetector. It contributes significantly to the sensitivity of the receiver in an optical communication system and often determines repeater spacing in an optical communication system. Particularly important is the noise generated at the photodetector and the bandwidth of the photodetector.

For use in certain wavelength ranges, photodetectors are made with compound semiconductors containing phosphorus. For example, for many photodetector devices operating at about 1.3 µm (i.e., the 1.25-1.35 µm region), InP is conveniently used as a substrate material and an epitaxially grown material such as InGaAs is used as the active material. In such devices, low noise is particularly important especially where these photodetectors are used in optical communication systems.

An especially important source of noise in photodetectors is dark current. It is highly desirable to minimize dark current in photodetectors because it adversely affects noise performance. Improved noise performance makes possible improved performance in a variety of optical systems including optical communication systems.

A process as set out in the preamble of claim 1 is disclosed by Suza and others in `Plasma enhanced CVD Si₃N₄ film applied to InP avalanche photodiodes', Japanese Journal of Applied Physics, Vol 19, No 11, November 1980, pages L675-L678. The Si₃N₄ capping layer is deposited by a low-temperature process, the substrates being kept at 250-300°C throughout.

With the invention as claimed devices with lower dark currents and noise figures can be made.

Various protective layers are useful to produce effective passivation without raising the sample temperature above about 250 to 300 degrees C. Particularly useful as a protective layer is silicon nitride (SiNₓ) put down by plasma chemical vapour deposition. A particularly useful procedure is to deposit a limited thickness of dielectric (generally 20 to 50 nanometres and preferably 30 nanometres) at a temperature less than 250 degrees C and then the remaining thickness (generally up to about 5 micrometres) at less than 400 degrees C.

Photodetectors sensitive in the 1.0-1.6 µm region (generally the region around 1.3 µm) can be made with InP substrates and active regions of InGaAs (typical composition about In_{0.53}Ga_{0.47}As).

J. D. Oberstar and B. G. Streetman, Thin Solid Films, vol. 103, No. 1/2, (1983), pages 17-26, disclose encapsulating InP bodies prior to heat treatment such as annealing, so as to prevent degradation due to evaporation of phosphorus.

The invention is based on the discovery that in fabricating photodiodes made from III-V compound semiconductors on substrates containing phosphorus, minimizing exposure to high temperatures while non-phosphorus-containing surfaces are exposed (prior to capping with a dielectric), leads to superior properties, especially lower noise and lower dark current or leakage current. Various procedures are available to ensure minimum exposure to high temperatures without sacrificing other device properties, such as device reliability and device lifetime.

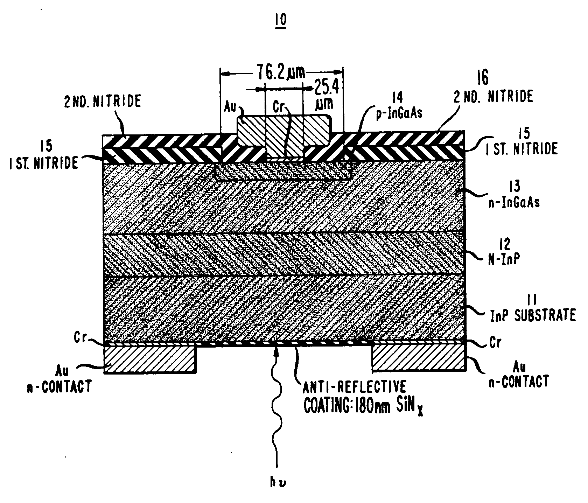

An embodiment of the invention will now be described by way of example with reference to the accompanying drawing in which the Figure shows a diagram of a typical photodetector with InP substrate, made in accordance with the invention.

The process to be described has the following features. First, the photodiode wafer is not exposed to temperatures above about 300 degrees C (preferably 250 degrees C) prior to capping with a dielectric. Second, during diffusion processes where the photodiode is exposed to relatively high temperatures (generally 450 to 650 degrees C with 500 to 600 degrees C preferred), the time of diffusion (i.e., time the photodiode is exposed to these high temperatures) should be minimized, generally to less than three hours, preferably to less than two or even one hour.

Also, an additional optional feature is to remove some of the surface of the active material (generally InGaAs) grown epitaxially at relatively high temperatures on the InP substrate, prior to further processing. This may be done by an etching procedure which removes several tenths of a micrometer. As stated above, this procedure is optional and may be done to thin the epitaxial layer to a desired thickness as well as remove damaged material.

The Figure shows a cross-sectional view of a typical confined-contact planar PIN photodiode with double nitride passivation. The structure, *10*, is made up of an InP substrate, 11, within a thin buffer layer, 12 (2 to 6 µm thick) of n-type InP. This buffer layer is grown on the substrate by an epitaxial growth procedure such as liquid phase epitaxial growth. An active layer, 13, is made of n-type InGaAs grown by a liquid phase epitaxial procedure. The composition is adjusted to lattice match with the InP buffer layer (typical composition within ±10 mole percent In_{0.53}Ga_{0.47}As). A p type InGaAs region, 14, is made by diffusing zinc into the InGaAs as described below.

The structure should not be exposed to excessively high temperatures for excessively long period of time before capping the active material (the InGaAs) with a dielectric or passivating material. The active material is capped with a first SiNₓ layer 15. A typical procedure is the use of a plasma chemical vapour deposition for nine minutes at 250 degrees C using a mixture of 2 percent SiH₄ in argon metered into the reaction chamber at 20 cc/minute and nitrogen gas metered at the rate of 134 cc/minute.

The temperature of the surface can usually be increased after deposition of a few tens of nanometres (e.g. 20 nanometres) of SiNₓ. Typically, the temperature is increased to between 300 and 400 degrees C.

After capping, the structure may be exposed to higher temperatures, but it is preferred that time of exposure to the higher temperatures be limited when the capping substance is removed. Generally, such a high-temperature exposure is required during diffusion in the p-type region, 14, in the InGaAs.

The p-type region 14 of the InGaAs is made by exposure to zinc vapour at a temperature below 600 degrees C (generally 500-600 degrees C with 550±20 degrees preferred) for a time under two hours (typically about one hour).

A representative procedure is as follows. A window is opened in the first nitride layer by a standard positive photoresist procedure. An oxygen plasma etching procedure is used to remove the SiNₓ in the window. The remainder of the photoresist is then removed by standard procedures. There remains a hole in the SiNₓ with diameter typically of about 80 micrometres (3 mils).

The doping procedure may be carried out in a variety of ways. A typical procedure involves diffusion from the vapour. Arsenic is usually included in the vapour to prevent loss of arsenic from the semiconductor surface. Generally, the wafer is sealed in a quartz ampoule containing the arsenic and zinc. For an ampoule volume of approximately 6 cc, about 6 mg of arsenic and 3 mg of zinc are used. The ampoule is heated to 550 degrees C for under two hours. The exact time depends on the thickness of the InGaAs layer and the amount of diffusion desired. The wafers are cooled and may be cleaned with a variety of solvents. Wafers are often tested at this point to determine the amount of leakage current.

The remainder of the processing procedure is conventional. A second layer 16 of dielectric, e.g. SiNₓ is put down as indicated in the Figure. A hole is opened [generally about 25 micrometres (1 mil)] by conventional procedures as described above and chromium and gold put down (typically by electron beam evaporation). Typical thicknesses are for chromium about 100 nanometres and for gold about 1300 nanometres. The remainder of the structure is fabricated by conventional means.

Photodiodes with active layers on phosphorus containing substrates fabricated as described typically have substantially lower dark currents than those fabricated at higher temperatures. PIN photodiodes can be regularly made with dark currents in the range from 5 to 20 nanoamperes at room temperature and 10 volts reverse bias.

## Claims

1. A process for fabricating a III-V compound semiconductor photodetector comprising forming a structure comprising a phosphorus-containing substrate (11), the surface of the substrate being at least partially covered with an active non-phosphorus-containing compound semiconductor layer, depositing a capping silicon nitride layer (15) on the surface of the active layer (13) and subjecting the structure to a heat treatment with at least part of the capping layer in place CHARACTERISED IN THAT
the capping layer is deposited in a two stage process, comprising:
a) depositing a thickness of at least 10 nanometres whilst maintaining the temperature of the structure below 300°C and
b) further depositing at a temperature in the range 300°C to 400°C.

2. A process as claimed in claim 1 wherein the temperature of the structure is kept below 250 degrees C until the capping layer (15) is at least 20 nanometres thick.

3. A process as claimed in claim 1, wherein the temperature of the structure is kept below 250 degrees C until the capping layer (15) is at least 30 nanometres thick and below 400 degrees C for additional thicknesses up to 5 micrometres.

4. A process as claimed in any of the preceding claims wherein the substrate (11) is of InP and the active material layer (13) is n-type and is InGaAs and a buffer layer (12) of n-type InP is epitaxially deposited between the substrate (11) and the active material layer (13).

5. A process as claimed in any of the preceding claims wherein the active material layer (13) has a composition within ±10 mole percent of In_{0.53}Ga_{0.47}As.

6. A process as claimed in any of the preceding claims, wherein the heat treatment is a diffusion process comprising removing a portion of the capping layer (15) to expose a portion of the surface of the active layer (13) and diffusing a dopant into the exposed portion.

7. A process as claimed in claim 6 wherein the active layer (13) is of n-type InGaAs, the dopant is zinc and the diffusing is carried out by contacting the exposed portion with a vapour including zinc for less than two hours at a temperature between 500 and 600 degrees C to make the exposed portion p-type.

8. A process as claimed in claim 7 characterized in that arsenic is included in the vapour.

9. A process as claimed in any of the preceding claims characterized in that the capping layer is formed by plasma chemical vapour deposition.

## Patentansprüche

1. Verfahren zur Herstellung eines III-V Verbindungshalbleiter-Fotodetektors umfassend das Ausbilden einer Anordnung mit einem Phosphor enthaltenden Substrat (11), wobei die Oberfläche des Substrates wenigsten teilweise mit einer aktiven, keinen Phosphor enthaltenden Verbindungshalbleiterschicht bedeckt ist, Abscheiden einer Siliciumnitrit-Abdeckschicht (15) auf der Oberfläche der aktiven Schicht (13) und Aussetzen der Anordnung einer Wärmebehandlung, wobei sich wenigstens ein Teil der Abdeckschicht an ihrer Stelle befindet,
dadurch gekennzeichnet, daß
die Abdeckschicht in einem Zwei-Stufen-Verfahren abgeschieden wird, umfassend:
a) das Abscheiden einer Dicke von wenigstens 10 nm während die Temperatur der Anordnung unterhalb von 300 °C gehalten wird, und
b) ferner Abscheiden bei einer Temperatur in dem Bereich von 300 °C bis 400 °C.

2. Verfahren nach Anspruch 1,
bei dem die Temperatur der Anordnung unter 250 °C gehalten wird, bis die Abdeckschicht (15) wenigstens 20 nm dick ist.

3. Verfahren nach Anspruch 1,
bei dem die Temperatur der Anordnung unter 250 °C gehalten wird, bis die Abdeckschicht (15) wenigstens 30 nm dick ist und unter 400 °C für eine zusätzliche Dicke bis zu 5 µm.

4. Verfahren nach einem der vorhergehenden Ansprüche, bei dem das Substrat (11) aus InP besteht, das Material der aktiven Schicht (13) n-leitend ist und aus InGaAs besteht und eine Pufferschicht (12) aus n-leitendem InP epitaxial auf das Substrat (11) und die aktive Schicht (13) abgeschieden wird.

5. Verfahren nach einem der vorhergehenden Ansprüche, bei dem das Material der aktiven Schicht (13) eine Zusammensetzung von ± 10 mol% aus In_{0,53}Ga_{0,47}As.

6. Verfahren nach einem der vorhergehenden Ansprüche, bei dem die Wärmebehandlung ein Diffusionsprozeß ist, bei dem ein Teil der Abdeckschicht (15) zur Freilegung eines Teils der Oberfläche der aktiven Schicht entfernt und ein Dotierstoff in den freigelegten Teil eindiffundiert wird.

7. Verfahren nach Anspruch 6, bei dem die aktive Schicht (13) aus n-leitenden InGaAs besteht, der Dotierstoff Zink ist und die Diffusion ausgeführt wird, indem der freigelegte Teil in Kontakt mit einem Zink enthaltenden Dampf für weniger als zwei Stunden bei einer Temperatur zwischen 500 und 600 °C gebracht wird, um den freigelegten Teil p-leitend zu machen.

8. Verfahren nach Anspruch 7, dadurch gekennzeichnet, daß Arsen in dem Dampf enthalten ist.

9. Verfahren nach einem der vorhergehenden Ansprüche, dadurch gekennzeichnet, daß die Abdeckschicht durch eine chemische Plasma-Dampfabscheidung gebildet wird.

## Revendications

1. Un procédé de fabrication d'un photodétecteur à semiconducteurs à base d'un composé III-V, qui consiste à former une structure comprenant un substrat phosphoré (11), la surface du substrat étant au moins partiellement recouverte d'une couche active de semiconducteurs en un composé non phosphoré, à déposer une couche de recouvrement (15) en nitrure de silicium sur la surface de la couche active (13) et à soumettre la structure à un traitement thermique alors qu'une partie au moins de la couche de recouvrement est en place, caractérisé en ce que
la couche de recouvrement est déposée par un processus en deux stades comprenant
a) le dépôt d'une épaisseur d'au moins 10 nanomètres, tout en maintenant la température de la structure à une valeur inférieure à 300°C, et
b) le dépôt ultérieur à une température comprise entre 300°C et 400°C.

2. Un procédé selon la revendication 1, dans lequel la température de la structure est maintenue inférieure à 250°C jusqu'à ce que la couche de recouvrement (15) mesure au moins 20 nanomètres d'épaisseur.

3. Un procédé selon la revendication 1, dans lequel la température de la structure est maintenue inférieure à 250°C jusqu'à ce que la couche de recouvrement (15) mesure au moins 30 nanomètres d'épaisseur, et elle est maintenue inférieure à 400°C pour des épaisseurs supplémentaires jusqu'à 5 micromètres.

4. Un procédé selon l'une quelconque des revendications précédentes, dans lequel le substrat (11) consiste en InP et la couche de matériau actif (13) est de type n et consiste en InGaAs, et une couche tampon (12) en InP de type n est déposée par épitaxie entre le substrat (11) et la couche de matériau actif (13).

5. Un procédé selon l'une quelconque des revendications précédentes, dans lequel la couche de matériau actif (13) présente la composition In_{0,53}Ga_{0,47}As, avec une plage de tolérance correspondant à un pourcentage molaire de ± 10 %.

6. Un procédé selon 'une quelconque des revendications précédentes, dans lequel le traitement thermique est un traitement de diffusion qui comprend l'enlèvement d'une partie de la couche de recouvrement (15) pour mettre à nu une partie de la surface de la couche active (13) et la diffusion d'un dopant dans la partie à nu.

7. Un procédé selon la revendication 6, dans lequel la couche active (13) consiste en InGaAs de type n, le dopant est du zinc et la diffusion est effectuée en mettant en contact la partie à nu avec une vapeur qui contient du zinc, pendant moins de deux heures, à une température comprise entre 500 et 600°C, pour donner le type p à la partie à nu.

8. Un procédé selon la revendication 7, caractérisé en ce que la vapeur contient de l'arsenic.

9. Un procédé selon l'une quelconque des revendications précédentes, caractérisé en ce que la couche de recouvrement est formée par dépôt chimique en phase vapeur par plasma.
